(19) Europäisches Patentamt / European Patent Office / Office européen des brevets

(11) **EP 3 454 467 B1**

(12) **EUROPEAN PATENT SPECIFICATION**

(45) Date of publication and mention
of the grant of the patent:
**04.10.2023 Bulletin 2023/40**

(21) Application number: **17812642.1**

(22) Date of filing: **09.06.2017**

(51) International Patent Classification (IPC):
**F04D 33/00** (2006.01)    **F04D 27/00** (2006.01)
**H02P 23/00** (2016.01)

(52) Cooperative Patent Classification (CPC):
**F04D 33/00; B06B 1/04; F04D 27/001;**
**F04D 27/004; G01H 13/00; H02P 23/00;**
**H10N 30/20;** Y02B 30/70

(86) International application number:
**PCT/CN2017/087772**

(87) International publication number:
**WO 2017/215531 (21.12.2017 Gazette 2017/51)**

(54) **METHOD FOR ADJUSTING ELECTROMAGNETICALLY DRIVEN SWING PLATE AND ELECTROMAGNETICALLY DRIVEN SWING PLATE APPARATUS**

VERFAHREN ZUM VERSTELLEN VON ELEKTROMAGNETISCH ANGETRIEBENEN SCHWENKPLATTEN UND ELEKTROMAGNETISCH ANGETRIEBENE SCHWENKPLATTENVORRICHTUNG

PROCÉDÉ DE RÉGLAGE DE PLAQUE OSCILLANTE À ENTRAÎNEMENT ÉLECTROMAGNÉTIQUE ET APPAREIL À PLAQUE OSCILLANTE À ENTRAÎNEMENT ÉLECTROMAGNÉTIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **16.06.2016 CN 201610435610**

(43) Date of publication of application:
**13.03.2019 Bulletin 2019/11**

(73) Proprietor: **Huawei Technologies Co., Ltd.**
**Longgang**
**Shenzhen, Guangdong 518129 (CN)**

(72) Inventors:
• **DU, Hongdian**
**Shenzhen**
**Guangdong 518129 (CN)**
• **FENG, Zhihua**
**Shenzhen , Guangdong, 518129 (CN)**
• **LI, Liang**
**Shenzhen**
**Guangdong 518129 (CN)**

(74) Representative: **Epping - Hermann - Fischer**
**Patentanwaltsgesellschaft mbH**
**Schloßschmidstraße 5**
**80639 München (DE)**

(56) References cited:
| | |
|---|---|
| EP-A1- 2 743 512 | EP-A1- 2 960 521 |
| CN-A- 103 423 188 | CN-A- 104 601 041 |
| CN-A- 104 716 865 | JP-A- 2012 077 678 |
| US-A- 3 391 560 | US-A- 4 780 062 |
| US-B2- 6 713 942 | |

**Description**

**TECHNICAL FIELD**

This application relates to the field of semiconductor components, and more specifically, to a method for adjusting an electromagnetic drive blade and an electromagnetic drive blade apparatus.

**BACKGROUND**

With high integration of a semiconductor component, a volume of an electronic device is smaller. A conventional fan cannot meet a use requirement in scenarios such as muting and a long service life due to problems such as a volume and noise. Therefore, an electromagnetic drive blade becomes popular because of multiple advantages such as a small volume, low costs, no electromagnetic noise, a long service life, and low power consumption.

When an electromagnetic drive coil works, an alternating voltage signal is applied to the electromagnetic coil, and the blade swings under an action of an electromagnetic force. When a frequency of an alternating voltage is equal to a natural frequency of a blade, the blade reaches a maximum swing amplitude, thereby outputting a high-speed and directional steady airflow and generating effects of ventilation and cooling. However, due to a manufacturing problem, it is not easy to determine a natural resonance frequency of each blade to a value. A bigger problem is that although a natural frequency of each piezoelectric patch can be adjusted to a comparatively consistent state, after working for a period of time, the natural frequency of each blade may slightly change due to impact such as a parameter change and dust. This causes a trouble in manufacturing a fan, and imposes a high requirement on an operation environment.

The foregoing problems are one of important reasons why an electromagnetic drive blade is currently not used in batches for heat dissipation. How to enable a blade to be in a resonance operation state, output a maximum air volume, and meet an application requirement of batch production even in the cases of manufacturing precision deviation, dust deposit, and mechanical performance change is a to-be-resolved problem.

Document EP 2 743 512 A1 refers to a method for controlling a mechanical vibrating element driven by a driving means includes operating the driving means at an operation frequency for stimulating the vibrating element to oscillate at this frequency. The method also includes adjusting the operation frequency of the driving means for stimulating the vibration element at different frequencies and of determining a respective energy consumption of the driving means depending on the frequency at which the vibrating element oscillates. The resonance frequency of the oscillation of the vibrating element is identified as the frequency at which the energy consumption of the driving means is lowest and the driving means for stimulating the vibrating element can be operated at the resonance frequency.

Document US 3,391,560 A relates to an apparatus for determining the natural resonance frequency of a structure, comprising a driving transducer which sets the structure oscillating at twice the frequency of the electrical energy fed to the transducer, and a magnetic pickup, and means to prevent the pick-up producing voltage at other than the resonance frequency, the structure having a ferromagnetic layer adjacent the transducers. The transducer is connected in a bridge circuit and acts simultaneously as a driving and pick-up transducer. Equilibrium of the bridge exists when the structure is at rest. When the structure is vibrating an induced voltage appears between two terminals, which is applied, via a band pass filter tuned to reject harmonics of w and a limiter to stabilize the amplitude of vibration to a predetermined value, as feedback to an amplifier thereby providing a self-oscillation when its phase shift and gain are such that oscillating conditions are fulfilled. The drive circuit thus does not contain signals at the frequency of vibration 2w of the structure.

Document US 6,713,942 B2 discloses a piezoelectric device, such as a piezoelectric fan or microjet generator, for moving a fluid comprising a fluid-moving member having a first piezoelectric (PZT) actuator element coupled thereto to drive or actuate the movable member and a second piezoelectric (PZT) sensing element coupled thereto to provide feedback information related to fluid parameter. The second PZT element also can be used to drive the movable member in conjunction with the first PZT element. The feedback information can be used by a controller to control operation of the piezoelectric device.

Document US 4,780,062 A discloses a piezoelectric fan that includes a tuning-fork type vibrator having two sides. A first piezoelectric element is formed on each of the two sides of the vibrator. Further, an exciting electrode is formed on each of these first piezoelectric elements. Also, a feedback electrode is formed on one of the first piezoelectric elements an electrically insulated from the exciting electrode. Furthermore, a blade is attached to the tip of each of the two sides of the vibrator. Then, this piezoelectric fan is driven in a self-exciting fashion by feeding an output from the feedback electrode to the exciting electrode. Also, in this piezoelectric fan, a vibrational node is formed at nearly the middle point of the vibrator at free vibration.

Document EP 2 960 521 A1 refers to an apparatus that comprises an oscillation blade fan and to a method for cleaning the oscillation blade fan. The apparatus comprises a power source coupled to an oscillation blade fan. The oscillation blade fan comprises a driver and a planar body, or blade attached to the driver. In a first driving condition, the power source applies a first alternating electric excitation to the driver at a first excitation frequency. The driver, in turn, drives the planar body in response to the first alternating electric excitation causing the planar body to oscillate at a first oscillation frequency. In a second driving condition, the power source applies a second alternating electric excitation to the driver at a second excitation frequency. The driver, in turn, drives the planar body in response to the second alternating electric excitation causing the planar body to oscillate at a second oscillation frequency. The second oscillation frequency is higher than the first oscillation frequency to cause particles such as dust and dirt to be ejected from the planar body.

## SUMMARY

Embodiments of this application provide an electromagnetic drive blade apparatus, so as to enable a blade to be constantly in a resonance state during operation, and a method for adjusting an electromagnetic drive blade. The present invention is defined by the attached set of claims. Embodiments and aspects which are not covered by the invention should be considered as examples useful for understanding the invention.

The electromagnetic drive blade apparatus further includes a detection coil, and the detection coil is configured to detect the induced voltage generated by the blade; and the drive unit is specifically configured to use each drive signal in the drive signals of the multiple frequencies to drive the blade in the first duration, where the first duration is at least one swing period of the blade, the multiple frequencies are located in the first frequency range, and the first frequency range includes the resonance frequency of the blade; the detection unit is specifically configured to: in the second duration that starts from a time point at which each drive signal stops driving the blade, obtain, by using the detection coil, the induced voltage generated by the blade, where the second duration is at least one swing period of the blade; and the drive unit is further configured to determine, as the resonance frequency of the blade, the frequency of the drive signal that generates the induced voltage of a maximum amplitude and slowest attenuation and that is in the drive signals of the multiple frequencies.

Therefore, according to the electromagnetic drive blade apparatus in this embodiment of this application, an induced voltage generated by swinging is detected when a blade is driven at multiple resonance frequencies, so that a resonance frequency of the blade can be determined from the multiple resonance frequencies.

It should be understood that, when the electromagnetic drive blade apparatus further includes the detection coil, the input ends of the voltage sampling unit are connected to the detection coil, and voltages at two ends of the detection coil are obtained.

The electromagnetic drive blade apparatus further includes an automatic gain control unit, where the automatic gain control unit includes a first input end, a second input end, and an output end, where the first input end is connected to the detection coil, the first input end is configured to receive the voltages at the two ends of the detection coil, the second input end is connected to the drive coil, the second input end is configured to receive voltages at two ends of the drive coil, and the output end is connected to an input end of the power amplification unit; and the automatic gain control unit is configured to: under control of the voltages at the two ends of the drive coil, output a voltage whose frequency is the same as a voltage of the detection coil by using the output end.

With reference to the first aspect and the foregoing implementations, in a twelfth possible implementation of the first aspect, the electromagnetic drive blade apparatus further includes a power amplification unit, an operational amplifier, and a bridge, where the bridge includes a first bridge arm having the drive coil, a second bridge arm having a first resistor, a third bridge arm having a third resistor, and a fourth bridge arm having a fourth resistor; and a second end of the first bridge arm is connected to a first end of the second bridge arm, a second end of the third bridge arm is connected to a first end of the fourth bridge arm, a first output end of the power amplification unit is separately connected to a first end of the first bridge arm and a first end of the third bridge arm, a second output end of the power amplification unit is separately connected to a second end of the second bridge arm and a second end of the fourth bridge arm, two input ends of the operational amplifier are respectively connected to the second end of the first bridge arm and the second end of the third bridge arm, and an output end of the operational amplifier is connected to an input end of the power amplification unit; the operational amplifier is configured to perform a subtraction operation between an electric potential of the second end of the first bridge arm and an electric potential of the second end of the third bridge arm, and output a result to the power amplification unit; and the power amplification unit is configured to perform power amplification on a voltage that is output by the operational amplifier, obtain the new drive signal, and apply the new drive signal to two ends of the drive coil.

With reference to the first aspect and the foregoing implementations, in a thirteenth possible implementation of the first aspect, a ratio of internal resistance of the drive coil to the first resistor is a first ratio, a ratio of the second resistor to the third resistor is a second ratio, and the first ratio is equal to the second ratio.

Therefore, according to the electromagnetic drive blade apparatus in this embodiment of this application, a blade can keep swinging at a resonance frequency, thereby generating a maximum amplitude in a resonance state.

Therefore, according to the method in the embodiments of this application, a drive frequency of a drive coil is adjusted to be the same as a current resonance frequency of a blade, so that the blade can be constantly in a resonance state, and the blade may be in a resonance operation state even in the cases of manufacturing precision deviation, dust deposit, and mechanical performance change. Therefore, power consumption of a circuit is minimum, and an air volume generated when the blade swings is maximum.

According to a second aspect, a method for adjusting an electromagnetic drive blade is provided, where the electromagnetic drive blade includes a coil and a blade. The method includes: sending a drive signal to the drive coil, so as to drive, by using the drive signal, the blade to swing; and when a drive frequency of the drive signal of the drive coil is different from a resonance frequency of the blade, sending a new drive signal to the drive coil, where a drive frequency of the new drive signal is the resonance frequency, so that the drive coil drives the blade to swing.

With reference to the second aspect, in a second possible implementation of the second aspect, the method further includes: detecting the resonance frequency of the blade.

Therefore, the resonance frequency of the blade is detected, so that whether the drive frequency of the current drive signal is the same as the resonance frequency of the blade can be determined, and whether the new drive signal is sent to the drive coil is determined.

According to a third aspect, an apparatus is provided, including: a processor, a receiver, a transmitter, and a memory. The processor is connected to the memory by using a bus system, the memory is configured to store an instruction, and the processor is configured to execute the instruction stored in the memory, to control the receiver to receive a signal, and control the transmitter to send a signal, so that the apparatus executes the method according to the second aspect or any possible implementation of the second aspect.

According to a fourth aspect, a computer-readable medium is provided and is configured to store a computer program, where the computer program includes an instruction that is used to execute the method according to the first aspect or any possible implementation of the first aspect.

## BRIEF DESCRIPTION OF DRAWINGS

FIG 1 is a schematic structural diagram of an electromagnetic drive blade apparatus according to an embodiment of this application;
FIG 2 is a schematic structural diagram of an electromagnetic drive blade apparatus according to an embodiment of this application;
FIG 3 is a schematic structural diagram of an electromagnetic drive blade apparatus according to an embodiment of this application;
FIG 4 is a schematic structural diagram of an electromagnetic drive blade apparatus according to an embodiment of this application;
FIG 5 is a schematic structural diagram of an electromagnetic drive blade apparatus according to another embodiment of this application, wherein this embodiment is according to the invention.
FIG 6 is a schematic structural diagram of an electromagnetic drive blade apparatus according to another embodiment of this application;
FIG 7 is a schematic flowchart of a method for adjusting an electromagnetic drive blade according to still another embodiment of this application;
FIG 8 is a schematic structural diagram of an electromagnetic drive blade apparatus according to an embodiment of this application;
FIG 9 is a schematic diagram of a voltage signal according to an embodiment of this application;
FIG 10 is a schematic diagram of a voltage signal according to an embodiment of this application;
FIG 11 is a schematic diagram of a voltage signal according to an embodiment of this application;
FIG 12 is a schematic structural diagram of an electromagnetic drive blade apparatus according to an embodiment of this application;
FIG 13 is a schematic structural diagram of an electromagnetic drive blade apparatus according to an embodiment of this application;
FIG 14 is a schematic circuit diagram of voltage collection according to an embodiment of this application;
FIG 15 is a schematic circuit diagram of voltage collection according to an embodiment of this application; and
FIG 16 is a schematic structural diagram of an electromagnetic drive blade apparatus according to an embodiment of this application.

## DESCRIPTION OF EMBODIMENTS

The following describes the technical solutions in the embodiments of this application with reference to the accompanying drawings in the embodiments of this application.

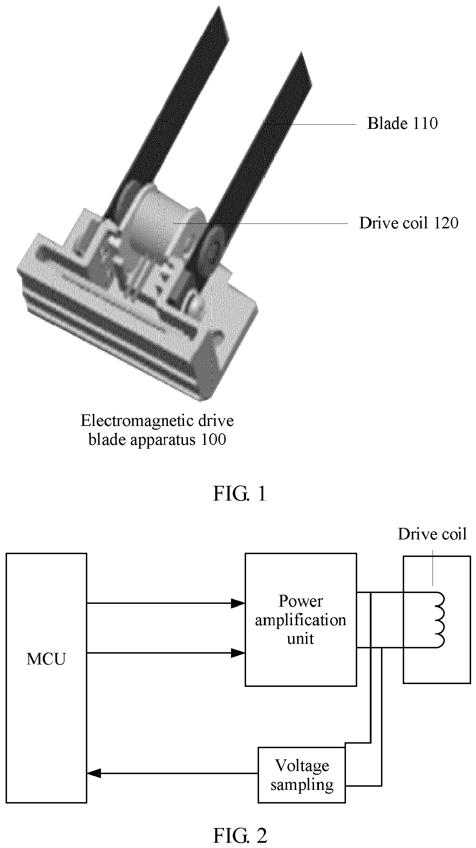

FIG 1 is a schematic structural diagram of an electromagnetic drive blade apparatus according to an embodiment of this application. As shown in FIG 1, the electromagnetic drive blade apparatus 100 includes:

a blade 110; and
a drive coil 120, configured to receive a drive signal, and drive, by using the drive signal, the blade 110 to swing, where when a frequency of the drive signal is different from a resonance frequency of the blade 110, the drive coil 120 receives a new drive signal, and drives, by using the new drive signal, the blade 110 to swing, and a frequency of the new drive signal is the resonance frequency of the blade 110.

Due to a difference of manufacturing precision between different blades, different blades may have different resonance frequencies. Even for one blade, because there may exist dust deposit, a mechanical performance change, and the like in a use process, a resonance frequency may change. Therefore, only a current resonance frequency of a blade can present a natural frequency of the blade in a current operation state.

Based on a resonance principle of a second-order system of a blade, when an electromagnetic coil is used to excite the blade, the blade is most easily driven to swing with a maximum swing amplitude only when a change frequency of a magnetic field of the electromagnetic coil is the same as the natural frequency of the blade. It should be understood that a drive voltage in this embodiment of this application is voltages at two ends of the electromagnetic coil that loads the electromagnetic drive blade, and may also be referred to as an excitation voltage. The natural frequency of the blade may also be referred to as the resonance frequency.

Due to a manufacturing problem, it is not easy to determine a natural resonance frequency of each blade to a value. Although a natural frequency of each piezoelectric patch can be adjusted to a comparatively consistent state, after working for a period of time, the natural frequency of each blade may slightly change due to impact such as a parameter change and dust, that is, the resonance frequency of the blade may change.

When an electromagnetic drive coil works, an alternating voltage signal is applied to the electromagnetic coil, and the blade swings under an action of an electromagnetic force. When a frequency of an alternating voltage is equal to the natural frequency of the blade, a fan using the blade as a semiconductor component can reach the maximum swing amplitude, thereby outputting a high-speed and directional steady airflow and generating effects of ventilation and cooling.

When a drive frequency applied to the drive coil 120 is different from the resonance frequency of the blade 110, the drive frequencies at two ends of the drive coil 120 need to be adjusted. Therefore, the drive coil 120 receives a new drive signal, and a drive frequency in the new drive signal is the same as the resonance frequency of the blade 110, so that a blade 210 can constantly work at the resonance frequency of the blade 110, and be in a resonance state, thereby generating a maximum amplitude.

Therefore, according to the method in the embodiments of this application, a new drive signal is received, and a drive frequency of a drive coil is adjusted to a resonance frequency of a blade, so that the blade swings at the resonance frequency, and the blade can be constantly in a resonance state.

In an embodiment not coverd by the claims, the electromagnetic drive blade apparatus further includes:

    a detection unit, where the detection unit is configured to detect the resonance frequency of the blade; and
    a drive unit, where the drive unit is configured to: generate a drive signal; adjust a drive frequency of the drive coil 120 when the drive frequency of the drive coil 120 is different from the resonance frequency of the blade 110, so that the drive frequency of the drive coil 120 is the resonance frequency; and send a new drive signal to the drive coil 120.

Specifically, due to a difference of manufacturing accuracy between different blades, different blades may have different resonance frequencies. Even for one blade, because there may exist dust deposit, a mechanical performance change, and the like in a use process, a resonance frequency may change. Therefore, the detection unit detects a resonance frequency of the blade 110 in a current state, and obtains a natural frequency of the blade 110 in the current operation state, so as to adjust drive frequencies at the two ends of the drive coil 120.

Specifically, when the drive frequency of the drive coil 120 is different from the resonance frequency of the blade 110, the drive unit may output the new drive signal, and the signal may adjust the drive frequency applied to the drive coil 120, so that the blade 110 can constantly work at the resonance frequency, thereby generating a maximum amplitude in a resonance state.

In a specific implementation process, whether a difference between the resonance frequency of the blade 110 and the drive frequency is greater than a specific preset threshold can be determined, and then the drive frequency of the drive coil is adjusted, for example, the preset threshold may be 0.3 Hz, 0.5 Hz, or the like, and usually is less than 0.5 Hz. It should be understood that this application is not limited thereto.

Therefore, according to the method in the embodiments of this application, a drive frequency of a drive coil is adjusted to be the same as a current resonance frequency of a blade, so that the blade can be constantly in a resonance state, and the blade may be in a resonance operation state even in the cases of manufacturing precision deviation, dust deposit, and mechanical performance change.

Optionally, the drive unit is further configured to separately use multiple drive frequencies to drive the blade 110 in first duration, where the multiple drive frequencies are located in a first frequency range, and the first duration is at least one blade period of the blade. The detection unit is specifically configured to: separately obtain a generated induced voltage in second duration that starts from a time point at which driving of the blade 110 is stopped, where the second duration is at least one blade period of the blade; and determine, as the resonance frequency of the blade, a drive frequency corresponding to an induced voltage that is of a maximum amplitude and slowest attenuation and that is in induced voltages generated by the multiple drive frequencies.

It should be understood that the first duration is a preset period of time, for example, may be set between 0.1 second and 1 second. A determining criterion for the first duration is that a blade may be almost fully pushed to swing with nearly 90% of the maximum swing amplitude at a natural frequency point; therefore, longer first duration is better for accurately finding the resonance frequency.

The second duration is also a preset period of time, and the second duration is used to detect a frequency of the induced voltage generated by the blade. If the second duration is excessively short, an attenuation law of a signal cannot be determined; and if the second duration is excessively long, a time is wasted. Therefore, the second duration may be selected between 0.1 second and 1 second, and this application is not limited thereto.

In a specific implementation, the resonance frequency of the blade may change in a frequency range, and the resonance frequency of the blade can be obtained simply by changing a drive frequency in the specific frequency range. The specific frequency range is referred to as the first frequency range, and the first frequency range is a most possible frequency range estimated according to a condition of design and manufacture, including the resonance frequency of the blade. Usually, the resonance frequency does not exceed the range, for example, a natural resonance frequency designed for the blade is 60 Hz, and the first frequency range may be set from 55 Hz to 65 Hz. A possibility that a newly-made blade exceeds the frequency is extremely slim; therefore, the drive frequency is changed in a range from 55 Hz to 65 Hz, so that the resonance frequency of the blade can be obtained. It should be understood that the digits are merely examples, and this application is not limited thereto.

Specifically, when a drive frequency is used to drive the blade 110 in the first duration, the blade 110 is excited by the drive coil 120 to swing. After the first duration ends, the excitation of the drive coil 120 is stopped. In the following second duration, the blade 110 further swings for a period of time. When swinging in the second duration, the blade 110 performs a movement of cutting a magnetic induction line, and therefore an induced voltage is generated on the drive coil 120. The induced voltage is detected in the second duration, and an induced voltage generated under the drive frequency condition is obtained.

It should be understood that the electromagnetic drive blade apparatus may further include a detection coil. In the second duration after driving of the coil is stopped, the detection coil detects the induced voltage generated by the blade 110, so that the drive unit determines, according to the induced voltage detected by the detection coil, to send the new drive signal to the drive coil 120 when the drive frequency of the drive coil 120 needs to be adjusted. A drive frequency corresponding to an induced voltage that is of a maximum amplitude and slowest attenuation and that is in induced voltages generated by the multiple drive frequencies is the resonance frequency of the blade.

Specifically, when drive frequencies of drive voltages applied to two ends of the drive coil 120 greatly deviate from the natural frequency of the blade, an amplitude of the induced voltage detected by the detection unit is relatively small; when the drive frequencies are relatively close to the natural frequency, an amplitude of the induced voltage detected by the detection unit is relatively large, and attenuation is relatively rapid; or when the drive frequencies are the same as the natural frequency of the blade, an amplitude of the induced voltage generated by the blade is relatively high, and attenuation is relatively slow. According to the foregoing steps, the drive coil is driven by using multiple different drive frequencies, induced voltages generated by a blade at different drive frequencies are detected, and multiple different induced voltages can be obtained. By comparing the multiple different induced voltages, a drive frequency corresponding to a voltage of a maximum amplitude and slowest attenuation is determined as a resonance frequency or a natural frequency of the blade.

In an embodiment of this application not covered by the claims, as shown in FIG 2, the detection unit includes a voltage sampling unit. Two input ends of the voltage sampling unit are connected to two ends of the drive coil, and the voltage sampling unit is configured to obtain the induced voltage generated by the blade. The drive unit includes a micro control unit and a power amplification unit, where an input end of the micro control unit is connected to an output end of the voltage sampling unit, an output end of the micro control unit is connected to an input end of the power amplification unit, and two output ends of the power amplification unit are connected to the two ends of the drive coil, where the micro control unit is configured to receive the induced voltage obtained by the voltage sampling unit, determine the new drive signal according to the induced voltage obtained by the voltage sampling unit, and send the new drive signal to the power amplification unit; and the power amplification unit is configured to perform power amplification on the new drive signal and apply the new drive signal to the two ends of the drive coil.

It should be understood that for brevity, FIG 2 does not show a blade that is coupled to a drive coil.

Therefore, according to the electromagnetic drive blade apparatus in this embodiment of this application, an induced voltage generated by swinging is detected when a blade is driven at multiple resonance frequencies, so that a resonance frequency of the blade can be determined from the multiple resonance frequencies.

Optionally, the drive unit is specifically configured to separately use multiple drive frequencies to drive the blade 110 to swing, where the multiple drive frequencies are located in a second frequency range. The detection unit is specifically configured to separately obtain multiple drive currents required when the multiple drive frequencies drive the blade 110, and determine, as the resonance frequency of the blade 110, a drive frequency corresponding to a drive current of a minimum current value in multiple drive currents.

Specifically, when the drive coil 120 excites the blade 110 to swing, if the drive frequency is the same as the resonance frequency of the blade 110, an operation current at this drive frequency is a minimum value. Therefore, multiple different drive frequencies are used to drive the blade 110, operation currents of the blade 110 during swinging at different drive frequencies are detected, and multiple different operation current values are obtained. By comparing the multiple different operation current values, a drive frequency corresponding to a minimum operation current value may be determined as a resonance frequency or a natural frequency of the blade 110.

Optionally, a manner of consecutively adjusting a drive frequency in real time may be used, so that a current drive frequency remains at a natural frequency of the blade. Specifically, in a current operation frequency point, a current value of an operation circuit may be detected, and then a minor frequency increment is used to perform driving, and a current value after the drive frequency is increased is detected. If a current amplitude is reduced after the drive frequency is increased, the increased frequency is used as a reference frequency, and one frequency increment is continually added. The foregoing steps are repeated until the current value of the operation circuit does not change or becomes larger. If a current of the operation current increases, a frequency needs to be reduced by one minor increment. Comparison continues. If a current value becomes smaller after the frequency is reduced, the drive frequency is continually reduced until the operation current remains unchanged or is reduced. By analogy, the current drive frequency may be locked in the resonance frequency of the blade 110. This manner of adjusting a drive frequency is relatively smooth, and there is no pause on the blade.

Preferably, in a specific implementation, the resonance frequency of the blade may change in a frequency range, and the resonance frequency of the blade can be obtained simply by changing a drive frequency in the specific frequency range. The specific frequency range is referred to as a second frequency range, and the second frequency range is a most possible frequency range estimated according to a condition of design and manufacture, and the second frequency range includes the resonance frequency of the blade. Usually, the resonance frequency does not exceed the range, for example, a natural resonance frequency designed for the blade is 60 Hz, and the second frequency range may be set from 55 Hz to 65 Hz. A possibility that a newly-made blade exceeds the frequency is extremely slim; therefore, the drive frequency is changed in a range from 55 Hz to 65 Hz, so that the resonance frequency of the blade can be obtained. It should be understood that the digits are merely examples, and this application is not limited thereto.

When the detection unit determines a current resonance frequency of the blade, a current drive frequency is adjusted by the drive unit to be consistent at the current resonance frequency of the blade, so that the blade can be in a resonance state, and a swing amplitude of the blade is maximum.

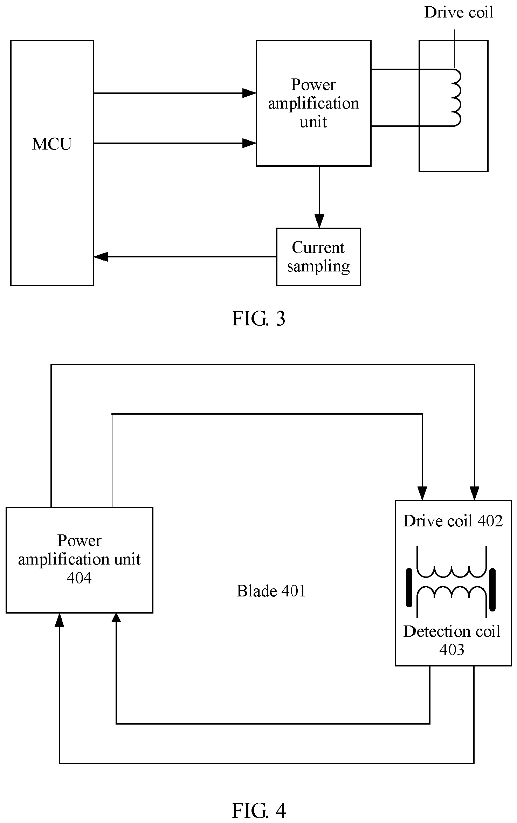

In an embodiment of this application not covered by the claims, as shown in FIG 3, the detection unit includes a current sampling unit, and the current sampling unit is configured to obtain a current of a drive signal required to drive the blade; and the drive unit includes a micro control unit and a power amplification unit, where an input end of the micro control unit is connected to an output end of the current sampling unit, an output end of the micro control unit is connected to an input end of the power amplification unit, and two output ends of the power amplification unit are connected to two ends of the drive coil; the micro control unit is configured to receive the current value obtained by the current sampling unit, determine the new drive signal, and send the new drive signal to the power amplification unit; and the power amplification unit is configured to perform power amplification on the new drive signal, and apply the new drive signal to the two ends of the drive coil.

It should be understood that for brevity, FIG 3 does not show a blade that is coupled to a drive coil.

Therefore, according to the electromagnetic drive blade apparatus in this embodiment of this application, a current value in a drive circuit is detected when a blade is driven at multiple resonance frequencies, so that a resonance frequency of the blade can be determined from the multiple resonance frequencies.

Optionally, the drive unit is specifically configured to drive the blade 110 to swing in third duration. The detection unit is specifically configured to: in fourth duration that starts from a time point at which driving of the blade 110 is stopped, detect an induced voltage generated by the blade, and determine a frequency of the induced voltage as the resonance frequency of the blade.

Specifically, after a circuit is powered on, the drive unit drives the blade 110 for a period of time, and then stops driving. In this case, the blade 110 swings freely. The detection unit detects a frequency of the induced voltage generated by the blade 110, and the frequency of the induced voltage generated by the blade 110 is the resonance frequency of the blade 110. A drive frequency of an operation circuit is adjusted to the resonance frequency of the blade, thereby driving the blade to work at the resonance frequency.

The third duration and the fourth duration are also preset periods of time. Specifically, the third duration is at least one swing period of the blade, and the fourth duration is at least one swing period of the blade. The third duration is used to drive the blade to swing, for example, may be multiple periods of a drive signal, and is not limited in this application. The fourth duration is used to detect the frequency of the induced voltage generated by the blade. If the fourth duration is excessively short, an attenuation law of a signal cannot be determined; and if the fourth duration is excessively long, a time is wasted. Therefore, the fourth duration may be selected between 0.1 second and 1 second, and this application is not limited thereto.

In an embodiment of this application not covered by the claims, the electromagnetic drive blade apparatus further includes a detection coil and a power amplification unit, where the detection coil is configured to detect an induced voltage generated when the blade swings, two input ends of the power amplification unit are respectively connected to two ends of the detection coil, two output ends of the power amplification unit are respectively connected to two ends of the drive coil; and the power amplification unit is configured to obtain the new drive signal after performing power amplification on voltages at two ends of the detection coil, and apply the new drive signal to the two ends of the drive coil.

Specifically, as shown in FIG 4, the electromagnetic drive blade apparatus includes a blade 401, a drive coil 402, a detection coil 403, and a power amplification unit 404. The drive coil 402 is configured to drive the blade 401 to swing, the detection coil 403 is configured to detect an induced voltage generated when the blade 401 swings, and the detection coil 403 may be coiled with the drive coil 402, or may be separately coiled. The detection coil 402 and the drive coil 403 shown in the figure are separately coiled.

Specifically, after the circuit shown in FIG 4 is closed and is powered on, two ends of the drive coil 402 generate a noise voltage, so that the blade 401 may be driven by noise in the circuit and slightly swing. The detection coil 403 may detect an induced voltage generated by the blade, and a frequency of the induced voltage generated by the blade 401 is a resonance frequency of the blade 401. After power amplification is performed, by the power amplification unit, on an induced voltage signal that is output by the detection coil 403, a new drive signal is obtained, and then the new drive signal is applied to the two ends of the drive coil 402, so that the blade 401 can work at the resonance frequency.

In an embodiment of this application according to the claims, thus according to the invention, the electromagnetic drive blade apparatus further includes an automatic gain control unit, where the automatic gain control unit includes a first input end, a second input end, and an output end, the first input end is connected to the detection coil, the first input end is configured to receive voltages at two ends of the detection coil, the second input end is connected to the drive coil, the second input end is configured to receive voltages at the two ends of the drive coil, the output end is connected to an input end of the power amplification unit, and the automatic gain control unit is configured to: under control of the voltages at the two ends of the drive coil, output a voltage whose frequency is the same as a voltage of the detection coil by using the output end.

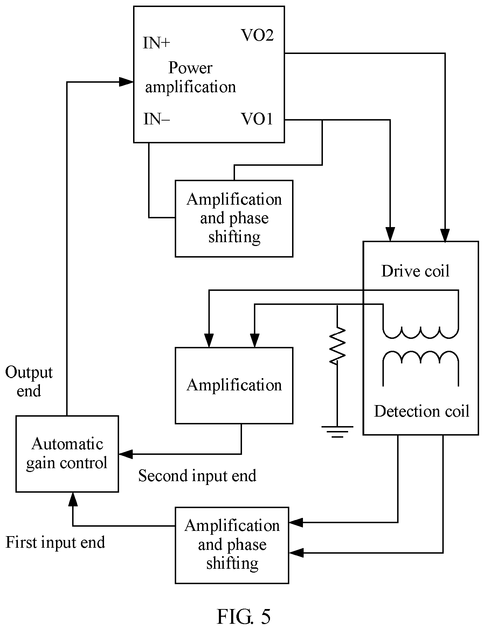

It should be understood that in a specific implementation process, the electromagnetic drive blade apparatus may further include an amplification unit, an amplification and phase-shift unit, and the like. As shown in FIG 5, after the amplification and phase shifting are performed on the induced voltage detected by the detection coil, the induced voltage is input into the automatic gain control unit. In addition, a sample voltage of the drive coil is amplified and is sent to the automatic gain control unit. In this way, under control of the received drive voltage, the automatic gain control unit outputs an output voltage that suppresses a voltage frequency of the detection coil. After power amplification is performed on a signal of the output steady voltage by the power amplification unit, the signal is re-applied to the two ends of the drive coil, so that a circuit in an entire electromagnetic drive blade apparatus remains in a self-excited oscillation state, that is, the blade can perform oscillation and swinging at the resonance frequency of the blade.

Therefore, according to the electromagnetic drive blade apparatus in this embodiment of this application, a blade can keep swinging at a resonance frequency, thereby generating a maximum amplitude in a resonance state.

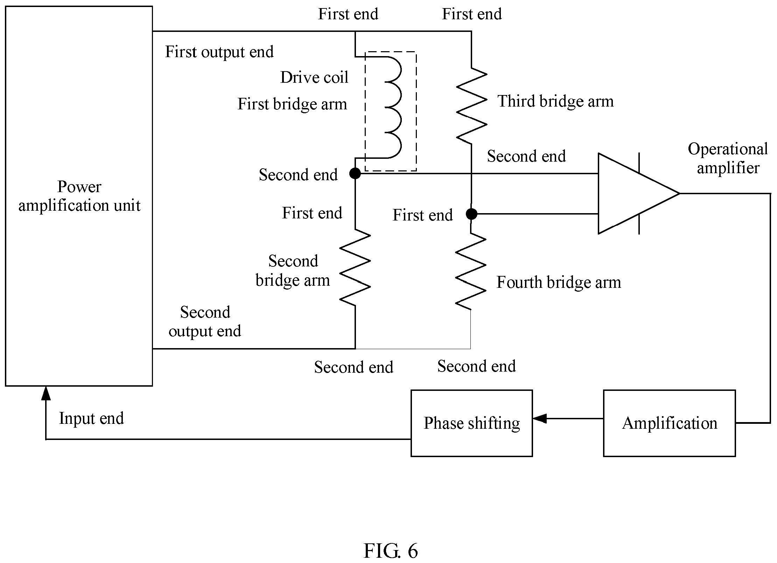

In an embodiment of this application not covered by the claims, the electromagnetic drive blade apparatus further includes a power amplification unit, an operational amplifier, and a bridge. As shown in FIG 6, the bridge includes a first bridge arm having the drive coil, a second bridge arm having a first resistor, a third bridge arm having a third resistor, and a fourth bridge arm having a fourth resistor. A first end of the first bridge arm is connected to a first end of the second bridge arm, a second end of the third bridge arm is connected to a first end of the fourth bridge arm, a first output end of the power amplification unit is separately connected to the first end of the first bridge arm and a first end of the third bridge arm, a second output end of the power amplification unit is separately connected to a second end of the second bridge arm and a second end of the fourth bridge arm, two input ends of the operational amplifier are respectively connected to a second end of the first bridge arm and the second end of the third bridge arm, and an output end of the operational amplifier is connected to an input end of the power amplification unit. The operational amplifier is configured to perform a subtraction operation between an electric potential of the second end of the first bridge arm and an electric potential of the second end of the third bridge arm, and output a result to the power amplification unit. The power amplification unit is configured to perform power amplification on a voltage that is output by the operational amplifier, obtain the new drive signal, and apply the new drive signal to two ends of the drive coil.

Specifically, after the power amplification unit applies a voltage to the bridge, when the blade does not swing, an electric potential difference between the electric potential of the second end of the first bridge arm and the electric potential of the second end of the third bridge arm is a specified value. When the blade swings, an induced voltage is generated, so that a difference between voltages at the two output ends changes. When a resistance value relationship among internal resistance of the drive coil, a first resistor, a second resistor, and a third resistor, the operational amplifier picks the changed voltage value, that is, the induced voltage generated when the blade swings can be picked by the operational amplifier, thereby obtaining a resonance frequency of the blade. After amplification and phase shifting are performed on the voltage, the voltage is input into the power amplification unit, the new drive signal is obtained, and the power amplification unit can apply the new drive signal to the two ends of the drive coil. The power amplification unit may be an H-bridge circuit, and this application is not limited thereto.

Preferably, a ratio of the internal resistance of the drive coil to the first resistor is a first ratio, a ratio of the second resistor to the third resistor is a second ratio, and the first ratio is equal to the second ratio.

That the ratio of the internal resistance to the first resistor is equal to the ratio of the second resistor to the third resistor is specifically: for example, the internal resistance of the coil is r, a resistance value of the first resistor is R1, a resistance value of the second resistor is R2, and a resistance value of the third resistor is R3. They meet the following relationship:

$$\frac{r}{R1} = \frac{R1}{R2}$$

In this case, after the power amplification unit applies a voltage to the bridge, when the blade does not swing, an electric potential difference between the electric potential of the second end of the first bridge arm and the electric potential of the second end of the third bridge arm is a specified value. When the blade swings, the induced voltage is generated, so that a difference between voltages at the two output ends of the bridge is not zero. The operational amplifier picks the voltage. In this case, a voltage frequency obtained by the operational amplifier is the same as the resonance frequency of the blade. After amplification and phase shifting are performed on the voltage, the voltage is input into the power amplification unit.

Therefore, according to the electromagnetic drive blade apparatus in this embodiment of this application, a blade can keep swinging at a resonance frequency, thereby generating a maximum amplitude in a resonance state.

Therefore, according to the method in the embodiments of this application, a drive frequency of a drive coil is adjusted to be the same as a current resonance frequency of a blade, so that the blade can be constantly in a resonance state, and the blade may be in a resonance operation state even in the cases of manufacturing precision deviation, dust deposit, and mechanical performance change. Therefore, power consumption of a circuit is minimum, and an air volume generated when the blade swings is maximum.

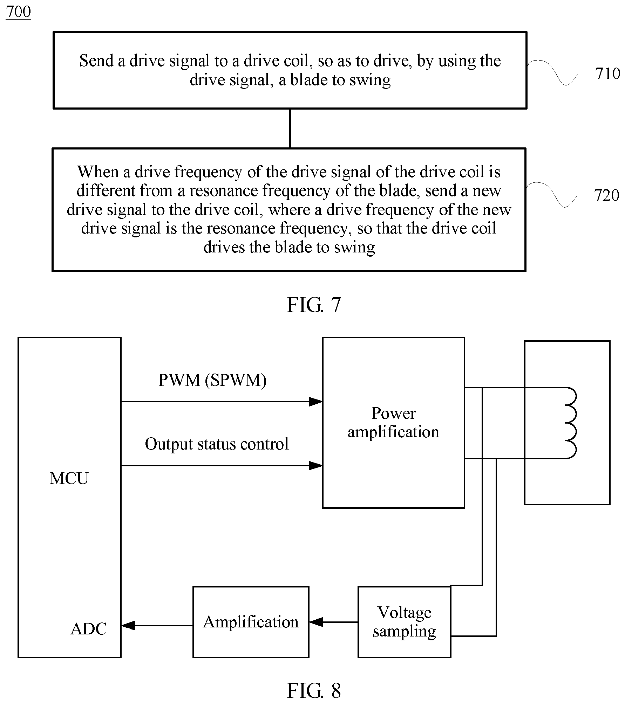

FIG 7 is a schematic flowchart of a method for adjusting an electromagnetic drive blade according to an embodiment of this application. The method may be executed by an operation apparatus of an electromagnetic drive blade, and the electromagnetic drive blade in the operation apparatus includes a drive coil and a blade. As shown in FIG 7, the method 700 includes the following steps:

Step 710: Send a drive signal to the drive coil, so as to drive, by using the drive signal, the blade to swing. Step 720: When a drive frequency of the drive signal of the drive coil is different from a resonance frequency of the blade, send a new drive signal to the drive coil, where a drive frequency of the new drive signal is the resonance frequency, so that the drive coil drives the blade to swing.

Optionally, in an embodiment of this application, the method further includes: detecting the resonance frequency of the blade.

In an embodiment of this application not covered by the claims, the detecting the resonance frequency of the blade includes: separately using multiple drive frequencies to drive the drive coil in first duration, where the multiple drive frequencies are located in a first frequency range; separately obtaining an induced voltage generated by the blade in second duration that starts from a time point at which the multiple drive frequencies stop driving the drive coil; and determining, as the resonance frequency of the blade, a drive frequency corresponding to an induced voltage that is of a maximum amplitude and slowest attenuation and that is in induced voltages generated by the multiple drive frequencies.

The first duration is a preset period of time, for example, may be set between 0.1 second and 1 second. A determining criterion for the first duration is that a blade may be almost fully pushed to swing with nearly 90% of the maximum swing amplitude at a natural frequency point; therefore, longer first duration is better for accurately finding the resonance frequency.

Preferably, in a specific implementation, the resonance frequency of the blade may change in a frequency range, and the resonance frequency of the blade can be obtained simply by changing a drive frequency in the specific frequency range. The specific frequency range is referred to as a first frequency range, and the first frequency range is a most possible frequency range estimated according to a condition of design and manufacture. Usually, the resonance frequency does not exceed the range, for example, a natural resonance frequency designed for the blade is 60 Hz, and the first frequency range may be set from 55 Hz to 65 Hz. A possibility that a newly-made blade exceeds the frequency is extremely slim; therefore, the drive frequency is changed in a range from 55 Hz to 65 Hz, so that the resonance frequency of the blade can be obtained. It should be understood that the digits are merely examples, and this application is not limited thereto.

In an embodiment of this application not covered by the claims, the detecting the resonance frequency of the blade includes: separately using multiple drive frequencies to drive the blade, where the multiple drive frequencies are located in a second frequency range; separately obtaining multiple drive currents that are required when the multiple drive frequencies drive the blade; and determining, as the resonance frequency of the blade, a drive frequency corresponding to a drive current with a minimum current value in the multiple drive currents.

When the drive coil excites the blade to swing, if the drive frequency is the same as the resonance frequency of the blade, an operation current at the drive frequency is a minimum value. Therefore, the drive coil is driven by using multiple different drive frequencies, operation currents generated when the blade swings at different drive frequencies are detected, and multiple different operation current values can be obtained. By comparing the multiple different operation current values, a drive frequency corresponding to a minimum operation current value is determined as a resonance frequency or a natural frequency of the blade.

Preferably, in a specific implementation, the resonance frequency of the blade may change in a frequency range, and the resonance frequency of the blade can be obtained simply by changing a drive frequency in the specific frequency range. The specific frequency range is referred to as a second frequency range, and the second frequency range is a most possible frequency range estimated according to a condition of design and manufacture. Usually, the resonance frequency does not exceed the range, for example, a natural resonance frequency designed for the blade is 60 Hz, and the second frequency range may be set from 55 Hz to 65 Hz. A possibility that a newly-made blade exceeds the frequency is extremely slim; therefore, the drive frequency is changed in a range from 55 Hz to 65 Hz, so that the resonance frequency of the blade can be obtained. It should be understood that the digits are merely examples, and this application is not limited thereto.

In an embodiment of this application not covered by the claims, the detecting the resonance frequency of the blade includes: driving the blade to swing in third duration; in fourth duration that starts from a time point at which driving of the blade is stopped, detecting an induced voltage generated by the blade; and determining a frequency of the induced voltage as the resonance frequency of the blade.

Specifically, after a circuit is powered on, the blade is driven for a period of time, and then driving is stopped. In this case, the blade swings freely. A frequency of the induced voltage generated by the blade is detected, and the frequency of the induced voltage generated by the blade is the resonance frequency of the blade. A drive frequency of an operation circuit is adjusted to the resonance frequency of the blade, thereby driving the blade to work at the resonance frequency.

It should be understood that a third frequency range is a most possible frequency range estimated according to a condition of design and manufacture. Usually, the resonance frequency does not exceed the range, for example, a natural resonance frequency designed for the blade is 60 Hz, and the third frequency range may be set from 55 Hz to 65 Hz. A possibility that a newly-made blade exceeds the frequency is extremely slim; therefore, the drive frequency is changed in a range from 55 Hz to 65 Hz, so that the resonance frequency of the blade can be obtained. It should be understood that the digits are merely examples, and this application is not limited thereto.

It should be understood that the method 700 in this embodiment of this application may be corresponding to an action of each unit in the electromagnetic drive blade apparatus 100 in this embodiment of this application. The foregoing and other operations and/or functions in the method 700 are separately used to implement corresponding procedures corresponding to the electromagnetic drive blade apparatus 100 in FIG 2. For brevity, details are not described herein again.

Therefore, according to the method in the embodiments of this application, a drive frequency of a drive coil is adjusted to be the same as a current resonance frequency of a blade, so that the blade can be constantly in a resonance state, and the blade may be in a resonance operation state even in the cases of manufacturing precision deviation, dust deposit, and mechanical performance change. Therefore, power consumption of a circuit is minimum, and an air volume generated when the blade swings is maximum.

FIG 8 is a schematic circuit diagram according to an embodiment of this application. The circuit is a specific circuit diagram that implements the electromagnetic drive blade apparatus shown in FIG 1.

As shown in FIG 8, a micro control unit (Microcontroller Unit, MCU) generates a drive signal, for example, the drive signal may be a sinusoidal pulse width modulation (Sinusoidal Pulse Width Modulation, SPWM) wave or a pulse-width modulation (Pulse-Width Modulation, PWM) wave. After power amplification is performed on the signal, the signal is applied to two ends of an electromagnetic coil, and the blade is driven by the electromagnetic coil to swing. For example, specifically, the power amplification unit may be an H-bridge drive circuit. In a normal operation state, the H-bridge circuit outputs a differential drive voltage. When an induced voltage generated by the blade needs to be detected, an output status of the H-bridge circuit is controlled to a high-impedance state, and the induced voltage after power amplification may be prevented from short-circuiting, so that a sampling circuit performs detection. After sampling and amplification are performed on a voltage of the induced voltage, an analog to digital converter (Analog to Digital Converter, ADC) collects a sampling signal. The drive unit in the electromagnetic drive blade apparatus shown in FIG 1 includes the H-bridge drive circuit, the micro control unit, and the like. The detection unit in the electromagnetic drive blade apparatus shown in FIG 1 includes the voltage sampling unit, a digital to analog converter, and the like. It should be understood that for brevity, the figure does not show a blade.

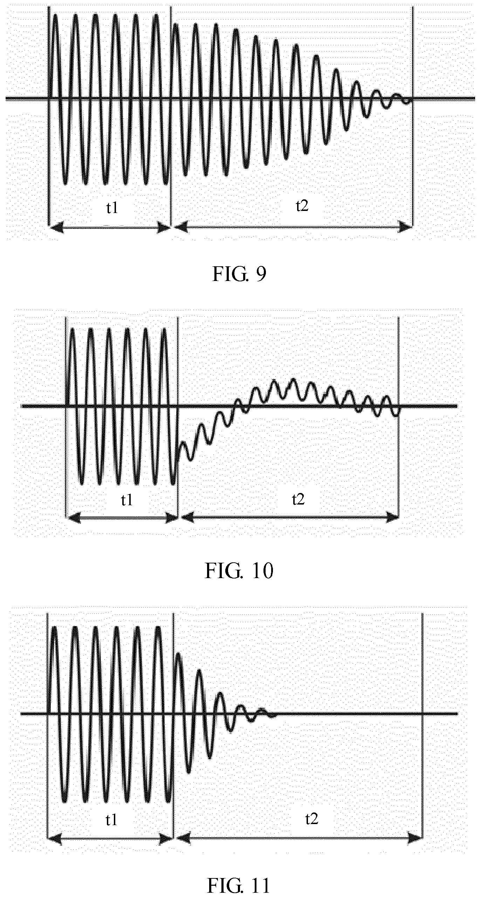

Specifically, in a period of time t1, the signal generated by the MCU excites a coil. After the period of time t1 ends, the signal generated by the MCU does not excite the coil any longer. In a period of time t2 that starts from a time point at which the period of time t1 ends, according to a change of the induced voltage signal collected by the ADC, whether a frequency of the voltage signal generated by the MCU is the same as the signal of the resonance frequency of the blade is determined. Specifically, when a frequency of an excitation voltage is the same as a natural frequency of the blade, it can be found that an amplitude of the induced voltage signal collected by the ADC is relatively high, and attenuation is slow, as shown in FIG 9. When a difference between the frequency of the excitation voltage and the natural frequency of the blade is relatively major, the amplitude of the induced voltage signal collected by the ADC is relatively small, as shown in FIG 10. When the frequency of the excitation voltage is relatively close to the natural frequency of the blade, the amplitude of the induced voltage signal collected by the ADC is relatively large, but attenuation is relatively rapid, as shown in FIG 11. Therefore, voltages of different frequencies may be used to drive the coil, for example, around a possible resonance frequency of the blade, the coil may be successively excited at a step of 1 Hz, so as to determine a resonance frequency of the blade. The MTC may drive the coil according to the resonance frequency, so that the blade generates a maximum swing amplitude.

Therefore, according to the method in the embodiments of this application, a drive frequency of a drive coil is adjusted to be the same as a current resonance frequency of a blade, so that the blade can be constantly in a resonance state, and the blade may be in a resonance operation state even in the cases of manufacturing precision deviation, dust deposit, and mechanical performance change. Therefore, power consumption of a circuit is minimum, and an air volume generated when the blade swings is maximum.

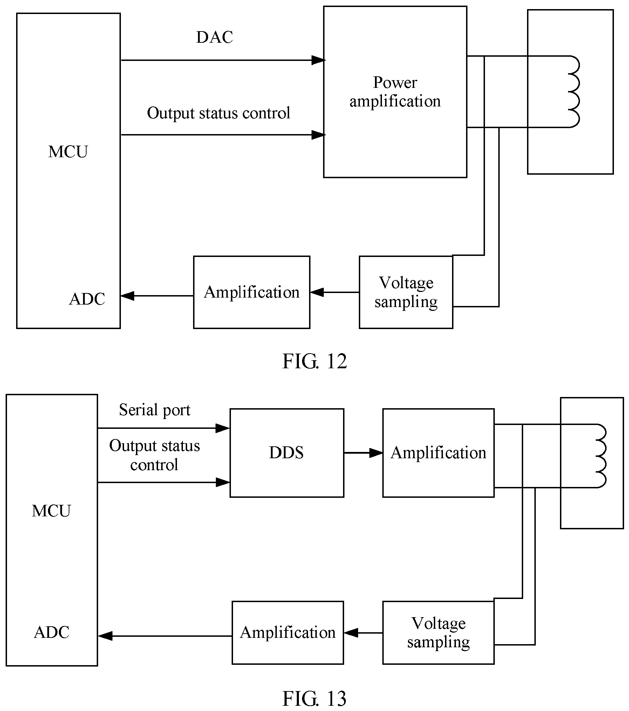

FIG 12 is a schematic circuit diagram according to another embodiment of this application.

As shown in FIG 12, a micro control unit (Microcontroller Unit, MCU) outputs a DAC drive signal. After passing through a power amplification unit, the drive signal excites a coil. The blade is driven by an excitation voltage to swing. When driving is stopped, an induced voltage generated by the blade is sampled by a voltage sampling unit, passes through the amplification unit, and is finally collected by an ADC unit. A specific operation procedure is the same as that in the embodiment shown in FIG 7. For brevity, details are not described herein again.

FIG 13 is a schematic circuit diagram according to still another embodiment of this application. As shown in FIG 13, a drive signal passes through a direct digital synthesizer (Direct Digital Synthesizer, DDS), and then power amplification is performed on the drive signal, thereby driving a coil. An induced voltage generated by a drive coil is sampled, amplified, and collected by an ADC module, so as to obtain an induced voltage generated by a blade. A specific operation procedure is the same as that in the embodiment shown in FIG 7. For brevity, details are not described herein again.

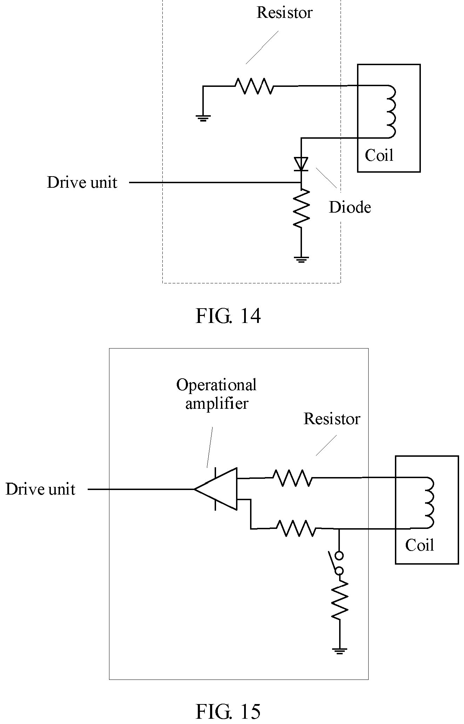

FIG 14 and FIG 15 are respectively structures of a typical sampling circuit of a voltage sampling unit. In FIG 14, one end of a drive coil is grounded, and the other end is grounded by using a diode. An output voltage signal passing through the diode is connected to a drive unit of an electromagnetic drive blade, and is used as an input signal of the drive unit.

In FIG 15, voltages at two ends of a coil are output to a drive unit after a related operation is performed by an operational amplifier.

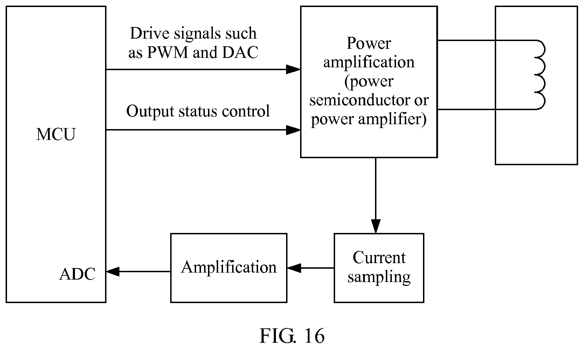

FIG 16 is a schematic circuit diagram according to an embodiment of this application.

As shown in FIG 16, a drive signal (which may be, for example, a PWM signal or a DAC signal) generated by an MCU passes through a power amplification unit and drives a coil, so that a blade swings. In this case, a drive current generated by the blade is detected, and the drive current is amplified by the amplification unit, and then is collected by an ADC. The drive unit in the electromagnetic drive blade apparatus shown in FIG 1 includes the power amplification unit, the micro control unit, and the like. The detection unit in the electromagnetic drive blade apparatus shown in FIG 1 includes a current sampling unit, a digital to analog converter, and the like. It should be understood that for brevity, the figure does not show a blade.

Specifically, the blade works under drive signals at multiple different frequencies generated by the MCU, and a drive current of the blade is collected. During operation of the blade, a frequency of a drive signal corresponding to a minimum current is a resonance frequency of the blade. The MCU can continually generate a drive signal of the resonance frequency, so that the blade can work constantly in a resonance state.

Specifically, a real-time and consecutive adjustment manner may be used, so that the blade can keep working at a fixed operation frequency. During operation at an initial drive frequency (for example, 35 Hz), a current amplitude is recorded, and then a minor frequency increment (for example, 0.5 Hz) is added on the basis of the initial drive frequency, to drive the blade, and a current amplitude at this moment is recorded. If the current amplitude is reduced after the frequency is increased, the increased drive frequency is used as a reference frequency, and one minor frequency increment is continually added, and the current amplitude is recorded. The foregoing steps are repeated until the current amplitude does not change or becomes larger. If the current amplitude increases, the drive frequency may be reduced until the current amplitude does not change or is increased. By analogy, the drive frequency may be locked in the resonance frequency of the blade. It should be understood that all the foregoing values are examples, and this application is not limited thereto.

Therefore, according to the method in the embodiments of this application, a drive frequency of a drive coil is adjusted to be the same as a current resonance frequency of a blade, so that the blade can be constantly in a resonance state, and the blade may be in a resonance operation state even in the cases of manufacturing precision deviation, dust deposit, and mechanical performance change. Therefore, power consumption of a circuit is minimum, and an air volume generated when the blade swings is maximum.

The invention is defined by the appended claims.

## Claims

1. An electromagnetic drive blade apparatus (100), comprising:

   a blade (110); and
   a drive coil (120, 402), configured to receive a drive signal, and configured to drive, by using the drive signal, the blade (110) to swing, wherein when a frequency of the drive signal is different from a resonance frequency of the blade (110), the drive coil (120, 402) is configured to receive a new drive signal, and is configured to drive, by using the new drive signal, the blade (110) to swing, and a frequency of the new drive signal is the resonance frequency,
   further comprising: a detection coil (403) and a power amplification unit, wherein
   the detection coil (403) is coupled and connected to the drive coil (120, 402), and is configured to detect an induced voltage generated when the blade (110) swings; and
   two input ends of the power amplification unit are respectively connected to two ends of the detection coil (403), two output ends of the power amplification unit are respectively connected to two ends of the drive coil (120, 402), and the power amplification unit is configured to obtain the new drive signal after performing power amplification on voltages at two ends of the detection coil (403), and apply the new drive signal to the two ends of the drive coil (120, 402),
   wherein the electromagnetic drive blade apparatus (100) further comprises an automatic gain control unit, and the automatic gain control unit comprises a first input end, a second input end, and an output end, wherein the first input end is connected to the detection coil (403), the first input end is configured to receive the voltages at the two ends of the detection coil (403), the second input end is connected to the drive coil (120, 402), the second input end is configured to receive voltages at two ends of the drive coil (120, 402), and the output end is connected to an input end of the power amplification unit; and the automatic gain control unit is configured to: under control of the voltages at the two ends of the drive coil (120, 402), output a voltage whose frequency is the same as a voltage of the detection coil (403) by using the output end.

2. A method for adjusting an electromagnetic drive blade (100), wherein the electromagnetic drive blade (100) comprises a drive coil (120, 402) and a blade (110), and the method comprises:

   sending a drive signal to the drive coil (120, 402), so as to drive, by using the drive signal, the blade (110) to swing; and
   when a drive frequency of the drive signal of the drive coil (120, 402) is different from a resonance frequency of the blade (110), sending a new drive signal to the drive coil (120, 402), wherein a drive frequency of the new drive signal is the resonance frequency, so that the drive coil (120, 402) drives the blade (110) to swing, wherein the electromagnetic drive blade (100) further comprises: a detection coil (403) and a power amplification unit, wherein
   the detection coil (403) is coupled and connected to the drive coil (120, 402), and detects an induced voltage generated when the blade (110) swings; and
   two input ends of the power amplification unit are respectively connected to two ends of the detection coil (403), two output ends of the power amplification unit are respectively connected to two ends of the drive coil (120, 402), and the power amplification unit obtains the new drive signal after performing power amplification on voltages at two ends of the detection coil (403), and applies the new drive signal to the two ends of the drive coil (120, 402),
   wherein the electromagnetic drive blade apparatus further comprises an automatic gain control unit, and the automatic gain control unit comprises a first input end, a second input end, and an output end, wherein the first input end is connected to the detection coil (403), the second input end is connected to the drive coil (120, 402), and the output end is connected to an input end of the power amplification unit,
   wherein the method further comprises:

   receiving, by the first input end of the automatic gain control unit, the voltages at the two ends of the detection coil,
receiving, by the second input end of the automatic gain control unit, voltages at two ends of the drive coil (120, 402), and
outputting, by the automatic gain control unit under control of the voltages at the two ends of the drive coil (120, 402), a voltage whose frequency is the same as a voltage of the detection coil (403) by using the output end.

**Patentansprüche**

1. Schaufeleinrichtung (100) mit elektromagnetischem Antrieb, die Folgendes umfasst:

eine Schaufel (110); und
eine Antriebsspule (120, 402), die konfiguriert ist, um ein Antriebssignal zu empfangen, und konfiguriert ist, um durch Verwenden des Antriebssignals die Schaufel (110) anzutreiben, zu schwingen, wobei, wenn sich eine Frequenz des Antriebssignals von einer Resonanzfrequenz von der Schaufel (110) unterscheidet, die Antriebsspule (120, 402) konfiguriert ist, um ein neues Antriebssignal zu empfangen, und konfiguriert ist, um durch Verwenden des neuen Antriebssignals die Schaufel (110) anzutreiben, zu schwingen, und eine Frequenz des neuen Antriebssignals die Resonanzfrequenz ist, die ferner Folgendes umfasst: eine Erfassungsspule (403) und eine Leistungsverstärkungseinheit, wobei die Erfassungsspule (403) mit der Antriebsspule (120, 402) gekoppelt und mit dieser verbunden ist und konfiguriert ist, eine induzierte Spannung zu erfassen, die erzeugt wird, wenn die Schaufel (110) schwingt; und
zwei Eingangsenden der Leistungsverstärkungseinheit jeweils mit zwei Enden der Erfassungsspule (403) verbunden sind, zwei Ausgangsenden der Leistungsverstärkungseinheit jeweils mit zwei Enden der Antriebsspule (120, 402) verbunden sind, und die Leistungsverstärkungseinheit konfiguriert ist, um das neue Antriebssignal nach einem Durchführen einer Leistungsverstärkung auf Spannungen an zwei Enden der Erfassungsspule (403) zu erhalten und das neue Antriebssignal an die zwei Enden der Antriebsspule (120, 402) anzulegen,
wobei die Schaufeleinrichtung (100) mit elektromagnetischem Antrieb ferner eine automatische Verstärkungssteuereinheit umfasst und die automatische Verstärkungssteuereinheit ein erstes Eingangsende, ein zweites Eingangsende und ein Ausgangsende umfasst, wobei das erste Eingangsende mit der Erfassungsspule (403) verbunden ist, das erste Eingangsende konfiguriert ist, um die Spannungen an den zwei Enden der Erfassungsspule (403) zu empfangen, das zweite Eingangsende mit der Antriebsspule (120, 402) verbunden ist, das zweite Eingangsende konfiguriert ist, um Spannungen an zwei Enden der Antriebsspule (120, 402) zu empfangen, und das Ausgangsende mit einem Eingangsende der Leistungsverstärkungseinheit verbunden ist; und die automatische Verstärkungssteuereinheit für Folgendes konfiguriert ist: unter Steuerung der Spannungen an den zwei Enden der Antriebsspule (120, 402), Ausgeben einer Spannung, deren Frequenz die gleiche wie eine Spannung der Erfassungsspule (403) ist, durch Verwenden von Ausgangsende.

2. Verfahren zum Einstellen einer Schaufel (100) mit elektromagnetischem Antrieb, wobei die Schaufel (100) mit elektromagnetischem Antrieb eine Antriebsspule (120, 402) und eine Schaufel (110) umfasst und das Verfahren Folgendes umfasst:

Senden eines Antriebssignals an die Antriebsspule (120, 402), um durch Verwenden des Antriebssignals die Schaufel (110) anzutreiben, zu schwingen; und
wenn eine Antriebsfrequenz des Antriebssignals der Antriebsspule (120, 402) sich von einer Resonanzfrequenz der Schaufel (110) unterscheidet, Senden eines neuen Antriebssignals an die Antriebsspule (120, 402), wobei eine Antriebsfrequenz des neue Antriebssignals die Resonanzfrequenz ist, so dass die Antriebsspule (120, 402) die Schaufel (110) antreibt, zu schwingen, wobei
die Schaufel (100) mit elektromagnetischem Antrieb ferner Folgendes umfasst: eine Erfassungsspule (403) und eine Leistungsverstärkungseinheit, wobei
die Erfassungsspule (403) mit der Antriebsspule (120, 402) gekoppelt und mit dieser verbunden ist und eine induzierte Spannung erfasst, die erzeugt wird, wenn die Schaufel (110) schwingt; und
zwei Eingangsenden der Leistungsverstärkungseinheit jeweils mit zwei Enden der Erfassungsspule (403) verbunden sind, zwei Ausgangsenden der Leistungsverstärkungseinheit jeweils mit zwei Enden der Antriebsspule (120, 402) verbunden sind, und die Leistungsverstärkungseinheit das neue Antriebssignal nach dem Durchführen einer Leistungsverstärkung auf Spannungen an zwei Enden der Erfassungsspule (403) erhält, und das neue Antriebssignal an die zwei Enden der Antriebsspule (120, 402) anlegt,
wobei die Schaufeleinrichtung mit elektromagnetischem Antrieb ferner eine automatische Verstärkungssteuereinheit umfasst und die automatische Verstärkungssteuereinheit ein erstes Eingangsende, ein zweites Eingangsende und ein Ausgangsende umfasst, wobei

das erste Eingangsende mit der Erfassungsspule (403) verbunden ist, das zweite Eingangsende mit der Antriebsspule (120, 402) verbunden ist und das Ausgangsende mit einem Eingangsende der Leistungsverstärkungseinheit verbunden ist,

wobei das Verfahren ferner umfasst:

Empfangen, durch das erste Eingangsende der automatischen Verstärkungssteuereinheit, der Spannungen an den zwei Enden der Erfassungsspule,

Empfangen, durch das zweite Eingangsende der automatischen Verstärkungssteuereinheit, der Spannungen an zwei Enden der Antriebsspule (120, 402), und

Ausgeben, durch die automatische Verstärkungssteuereinheit unter Steuerung der Spannungen an den zwei Enden der Antriebsspule (120, 402), einer Spannung, deren Frequenz die gleiche wie eine Spannung der Erfassungsspule (403) ist, durch Verwenden des Ausgangsendes.

## Revendications

1. Appareil à lame à entraînement électromagnétique (100), comprenant :

une lame (110) ; et
une bobine d'entraînement (120, 402), configurée pour recevoir un signal d'entraînement, et configurée pour entraîner, à l'aide du signal d'entraînement, la lame (110) à osciller, la bobine d'entraînement (120, 402) étant configurée, lorsqu'une fréquence du signal d'entraînement est différente d'une fréquence de résonance de la lame (110), pour recevoir un nouveau signal d'entraînement, et étant configurée pour entraîner, à l'aide du nouveau signal d'entraînement, la lame (110) à osciller, et une fréquence du nouveau signal d'entraînement étant la fréquence de résonance,
comprenant en outre : une bobine de détection (403) et une unité d'amplification de puissance, la bobine de détection (403) étant couplée et connectée à la bobine d'entraînement (120, 402), et étant configurée pour détecter une tension induite générée lorsque la lame (110) oscille ; et
deux extrémités d'entrée de l'unité d'amplification de puissance sont respectivement connectées à deux extrémités de la bobine de détection (403), deux extrémités de sortie de l'unité d'amplification de puissance sont respectivement connectées à deux extrémités de la bobine d'entraînement (120, 402), et l'unité d'amplification de puissance est configurée pour obtenir le nouveau signal d'entraînement après avoir effectué une amplification de puissance sur des tensions au niveau de deux extrémités de la bobine de détection (403), et appliquer le nouveau signal d'entraînement aux deux extrémités de la bobine d'entraînement (120, 402),
l'appareil à lame à entraînement électromagnétique (100) comprenant en outre une unité de commande automatique de gain, et l'unité de commande automatique de gain comprenant une première extrémité d'entrée, une seconde extrémité d'entrée et une extrémité de sortie, la première extrémité d'entrée étant connectée à la bobine de détection (403), la première extrémité d'entrée étant configurée pour recevoir les tensions au niveau des deux extrémités de la bobine de détection (403), la seconde extrémité d'entrée étant connectée à la bobine d'entraînement (120, 402), la seconde extrémité d'entrée étant configurée pour recevoir des tensions au niveau de deux extrémités de la bobine d'entraînement (120, 402), et l'extrémité de sortie étant connectée à une extrémité d'entrée de l'unité d'amplification de puissance ; et l'unité de commande automatique de gain étant configurée pour : sous la commande des tensions au niveau des deux extrémités de la bobine d'entraînement (120, 402), délivrer une tension dont la fréquence est la même qu'une tension de la bobine de détection (403) à l'aide de l'extrémité de sortie,

2. Procédé de réglage d'une lame à entraînement électromagnétique (100), dans lequel la lame à entraînement électromagnétique (100) comprend une bobine d'entraînement (120, 402) et une lame (110), et le procédé comprend :

l'envoi d'un signal d'entraînement à la bobine d'entraînement (120, 402), de manière à entraîner, à l'aide du signal d'entraînement, la lame (110) à osciller ; et
lorsqu'une fréquence d'entraînement du signal d'entraînement de la bobine d'entraînement (120, 402) est différente d'une fréquence de résonance de la lame (110), l'envoi d'un nouveau signal d'entraînement à la bobine d'entraînement (120, 402), une fréquence d'entraînement du nouveau signal d'entraînement étant la fréquence de résonance, de sorte que la bobine d'entraînement (120, 402) entraîne l'oscillation de la lame (110),

la lame à entraînement électromagnétique (100) comprenant en outre : une bobine de détection (403) et une unité d'amplification de puissance, la bobine de détection (403) étant couplée et connectée à la bobine d'entraînement (120, 402), et détectant une tension induite générée lorsque la lame (110) oscille ; et

deux extrémités d'entrée de l'unité d'amplification de puissance sont respectivement connectées à deux extrémités de la bobine de détection (403), deux extrémités de sortie de l'unité d'amplification de puissance sont respectivement connectées à deux extrémités de la bobine d'entraînement (120, 402), et l'unité d'amplification de puissance obtient le nouveau signal d'entraînement après avoir effectué une amplification de puissance sur des tensions au niveau de deux extrémités de la bobine de détection (403), et applique le nouveau signal d'entraînement aux deux extrémités de la bobine d'entraînement (120, 402),

l'appareil à lame à entraînement électromagnétique comprenant en outre une unité de commande automatique de gain, et l'unité de commande automatique de gain comprenant une première extrémité d'entrée, une seconde extrémité d'entrée et une extrémité de sortie,

la première extrémité d'entrée étant connectée à la bobine de détection (403), la seconde extrémité d'entrée étant connectée à la bobine d'entraînement (120, 402) et l'extrémité de sortie étant connectée à une extrémité d'entrée de l'unité d'amplification de puissance,

le procédé comprenant en outre :

la réception, par la première extrémité d'entrée de l'unité de commande automatique de gain, des tensions au niveau des deux extrémités de la bobine de détection,

la réception, par la seconde extrémité d'entrée de l'unité de commande automatique de gain, de tensions au niveau de deux extrémités de la bobine d'entraînement (120, 402), et

l'émission, par l'unité de commande automatique de gain sous la commande des tensions au niveau des deux extrémités de la bobine d'entraînement (120, 402), d'une tension dont la fréquence est la même qu'une tension de la bobine de détection (403) à l'aide de l'extrémité de sortie.

Electromagnetic drive
blade apparatus 100

FIG. 1

FIG. 2

FIG. 3

FIG. 4

FIG. 5

First end     First end

First output end

Drive coil

First bridge arm

Third bridge arm

Power
amplification unit

Second end

Second end

First end     First end

Operational
amplifier

Second
bridge arm

Fourth bridge arm

Second
output end

Second end     Second end

Input end

Phase shifting ◄─── Amplification

FIG. 6

700

| |
|---|
| Send a drive signal to a drive coil, so as to drive, by using the drive signal, a blade to swing |

710

| |
|---|
| When a drive frequency of the drive signal of the drive coil is different from a resonance frequency of the blade, send a new drive signal to the drive coil, where a drive frequency of the new drive signal is the resonance frequency, so that the drive coil drives the blade to swing |

720

FIG. 7

MCU

PWM (SPWM)

Output status control

Power amplification

ADC

Amplification

Voltage sampling

FIG. 8

FIG. 9

FIG. 10

FIG. 11

FIG. 12

FIG. 13

Resistor

Coil

Drive unit

Diode

FIG. 14

Operational
amplifier

Resistor

Drive unit

Coil

FIG. 15

FIG. 16

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2743512 A1
- US 3391560 A
- US 6713942 B2
- US 4780062 A
- EP 2960521 A1